# EUROPÄISCHE PATENTSCHRIFT

(11) **EP 0 665 645 B1**
(45) Veröffentlichungstag und Bekanntmachung des Hinweises auf die Patenterteilung: **18.04.2001**
(21) Anmeldenummer: 95101297.0
(22) Anmeldetag: 31.01.1995
(51) Int. Cl.: H03H 9/64

(54) **Transversal modengekoppeltes OFW-Resonatorfilter**
Transversal coupled mode saw resonatorfilter
Filtre résonateur, à couplage transversal de modes, à ondes acoustiques de surface

(30) Priorität: 31.01.1994 DE 4402824
(43) Veröffentlichungstag der Anmeldung: 02.08.1995
(73) Patentinhaber: EPCOS AG, 81541 München (DE)
(72) Erfinder: Anemogiannis, Kimon, Dr., Ing., D-81243 München (DE); Müller, Folkhard, Dipl.-Phys., D-80339 München (DE)
(74) Vertreter: Epping, Wilhelm, Dipl.-Ing.

(56) Entgegenhaltungen:
- FR-A- 2 313 811
- JEE JOURNAL OF ELECTRONIC ENGINEERING, Bd. 30,Nr. 315, März 1993 TOKYO JP, Seiten 26-29,38, XP 000348985 YOSHIHIKO YASUHARA 'MAKERS REFINE SAW FILTERS FOR USE IN CELLULAR PHONES'

## Beschreibung

Die vorliegende Erfindung betrifft ein transversal modengekoppeltes OFW-Resonatorfilter nach dem Oberbegriff des Patentanspruchs 1.

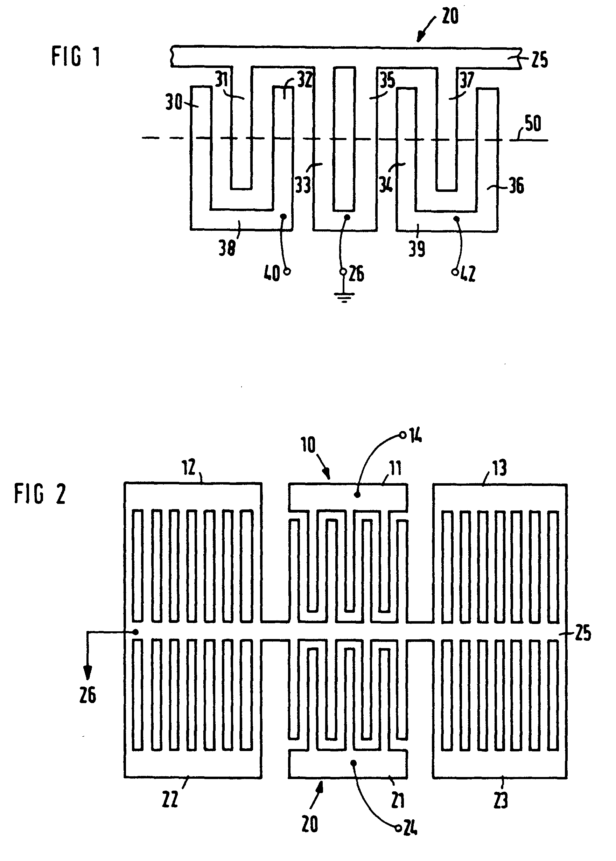

Derartige Resonatorfilter sind beispielsweise aus "1992 Ultrasonics Symposium", Seiten 39 bis 43 bekannt. Der prinzipielle Aufbau eines derartigen Resonatorfilters ist in Figur 2 dargestellt. Das Filter wird durch zwei Resonatoren 10 und 20 gebildet, die jeweils einen Interdigitalwandler 11 bzw. 21 sowie jeweils zwei auf entgegengesetzten Seiten der Interdigitalwandler 11 und 21 vorgesehen Reflektoren 12, 13 bzw. 22, 23 enthalten. Die beiden Reflektoren sind über eine gemeinsame Sammelschiene 25 elektrisch und akustisch miteinander gekoppelt. Die gemeinsame Sammelschiene 25 bildet dabei eine Masseschiene, die über einen schematisch dargestellten Masseanschluß 26 elektrisch zugänglich ist.

In Bezug auf die gemeinsame einen Masseanschluß bildende Sammelschiene 25 ist einer der Interdigitalwandler, beispielsweise der Interdigitalwandler 10 ein Eingangswandler und der andere Interdigitalwandler, beispielsweise der Interdigitalwandler 21 ein Ausgangswandler. Die Wandler sind dabei über jeweils einen Anschluß 14 - hier der Eingangsanschluß - bzw. 24 - hier der Ausgangsanschluß - elektrisch zugänglich.

Ein Problem bei derartigen Resonatorfiltern besteht darin, daß sie in Bezug auf die den Masseanschluß bildende gemeinsame Sammelschiene 25 nur unsymmetrisch ansteuerbar sind und daher in Schaltungen, die in Bezug auf Masse einen symmetrischen Anschluß verlangen, nicht eingesetzt werden können.

Zur Vermeidung des genannten Problems ist in Betracht gezogen worden, das Resonatorfilter über zusätzliche Komponenten in Form von Transformatoren anzukoppeln. Dies stellt jedoch einen erheblichen Aufwand dar.

Der vorliegenden Erfindung liegt die Aufgabe zugrunde, ein so ausgebildetes Resonatorfilter der in Rede stehenden Art anzugeben, daß es in Bezug auf Masse symmetrisch ansteuerbar ist.

Diese Aufgabe wird bei einem transversal modengekoppelten OFW-Resonatorfilter der eingangs genannten Art durch die Merkmale des kennzeichnenden Teils des Patentanspruchs 1 gelöst.

Eine Weiterbildung der Erfindung ist Gegenstand eines Unteranspruchs.

Die Erfindung wird nachfolgend anhand eines Ausführungsbeispiels gemäß den Figuren der Zeichnung näher erläutert. Es zeigt:
- Figur 1: ein Ausführungsbeispiel eines Interdigitalwandlers für ein in Bezug auf Masse symmetrisch ansteuerbares Resonatorfilter; und
- Figur 2: die oben bereits erläuterte Ausführungsform eines bekannten OFW-Resonatorfilters.

Der Interdigitalwandler gemäß Figur 1, der in Übereinstimmung mit Figur 2 mit 20 bezeichnet ist, besitzt ebenfalls in Übereinstimmung mit Figur 2 als eine Komponente die gemeinsame Sammelschiene 25. Der Interdigitalwandler 20 besitzt Elektrodenfinger 30 bis 33 bzw. 34 bis 37, die erfindungsgemäß so angeordnet sind, daß in Bezug auf eine senkrecht zur OFW-Ausbreitungsrichtung 50 liegende Spiegelachse eine Hälfte der Elektrodenfinger, das heißt die Elektrodenfinger 30 bis 33 spiegelbildlich zur anderen Hälfte der Elektrodenfinger liegen, das heißt spiegelbildlich zu den Elektrodenfingern 34 bis 37. Weiterhin ist erfindungsgemäß die auf der anderen Seite der gemeinsamen Sammelschiene 25 liegende Sammelschiene für die beiden Elektrodenfingerhälften 30 bis 33 bzw. 34 bis 37 getrennt, wodurch zwei Sammelschienenteile 38 und 39 entstehen. An diesen Sammelschienenteilen 38 und 39 liegen die Elektrodenfinger 30, 32 bzw. 34, 36. Aufgrund der Trennung der Sammelschiene in die beiden Sammelschienenteile 38 und 39 entstehen zwei getrennte Anschlußmöglichkeiten, die schematisch durch Anschlüsse 40 und 42 dargestellt sind. An diese beiden Anschlüsse 40, 42 kann ein symmetrisches elektrisches Signal angelegt oder abgegriffen werden, wobei akustisch das gleiche Signal wie im unsymmetrischen Fall nach Figur 2 vorhanden ist.

Ein mindestens einen Interdigitalwandler der in Figur 1 dargestellten Art enthaltendes Resonatorfilter, wie es in Figur 2 dargestellt ist, ist daher an den Anschlüssen 40, 42 symmetrisch und massefrei anschließbar.

Es ist darauf hinzuweisen, daß ein erfindungsgemäß ausgebildeter Interdigitalwandler der in Figur 1 dargestellten Art in einem Resonatorfilter nach Figur 2 sowohl als Eingangswandler als auch als Ausgangswandler verwendbar ist. Es kann sich also um einen Eingangswandler, einen Ausgangswandler oder beides handeln.

Es sei weiterhin darauf hingewiesen, daß ein Resonatorfilter in an sich bekannter Weise nicht ausschließlich aus zwei Resonatoren aufgebaut sein kann, wie dies in Figur 2 dargestellt ist. Vielmehr können auch mehrere Resonatoren der in Figur 2 dargestellten Art über gemeinsame Sammelschienen miteinander gekoppelt werden und erfindungsgemäß ausgebildete Interdigitalwandler der in Figur 1 dargestellten Art enthalten. Es entstehen dann gegenüber zweipoligen mehrpolige Filterkonfigurationen.

Die in Figur 1 dargestellte erfindungsgemäß Ausführungsform eines Interdigitalwandlers besitzt den weiteren Vorteil, daß die gemeinsame eine Masseschiene darstellenden Sammelschiene 25 an der Trennstelle zwischen den beiden Sammelschienenteilen 38 und 39 elektrisch herausgeführt werden kann, wodurch eine Reduzierung der Filtersperrdämpfung erzielbar ist. Dann werden die Finger 33 und 35 verlängert und mit der Masse 26 verbunden. Dies erweist sich gegenüber einer Ausführungsform nach Figur 2 deshalb als vorteilhaft, weil dort die gemeinsame Sammelschiene im Filterinneren praktisch elektrisch nicht anschließbar ist. Die gemeinsame Sammelschiene muß nämlich aus Gründen einer guten akustischen Kopplung der beiden Resonatoren möglichst schmal sein, so daß sie abgesehen von einer Herausführung am Filterrand elektrisch nicht zugänglich ist.

## Patentansprüche

1. Transversal modengekoppeltes OFW-Resonatorfilter mit mindestens zwei Resonatoren, die über eine gemeinsame Sammelschiene (25) elektrisch und akustisch miteinander gekoppelt sind, die jeweils mindestens einen Interdigitalwandler (11, 21) und jeweils mindestens zwei auf entgegengesetzten Seiten des Interdigitalwandlers (11, 21) angeordnete Reflektoren (12, 13, 22, 23) aufweisen, wobei einer der Interdigitalwandler (11) einen elektrischen Filtereingang (14), der andere Interdigitalwandler (21) auf der gegenüberliegenden Seite der gemeinsamen Sammelschiene (25) einen elektrischen Filterausgang (24) und die gemeinsame Sammelschiene (25) einen elektrischen Masseanschluß (26) bilden,
**dadurch gekennzeichnet,** daß
in mindestens einem der Interdigitalwandler Elektrodenfinger (30 bis 33, 34 bis 37) so angeordnet sind, daß in Bezug auf eine senkrecht zur OFW-Ausbreitungsrichtung (50) liegende Spiegelachse eine Hälfte der Elektrodenfinger (30 bis 33) spiegelbildlich zur anderen Hälfte der Elektrodenfinger (34 bis 37) liegt, und daß in diesem mindestens einen Interdigitalwandler die auf der entgegengesetzten Seite der gemeinsamen Sammelschiene (25) liegende Sammelschiene (38, 39) für die beiden Elektrodenfingerhälften (30 bis 33, 34 bis 37) zur Bildung zweier Filteranschlüsse (40, 42) getrennt ist, die zusammen einen symmetrischen Filterein- oder -ausgang bilden.

2. Resonatorfilter nach Anspruch 1, **dadurch gekennzeichnet,** daß die gemeinsame Sammelschiene (25) einen zwischen der Trennstelle der getrennten Sammelschiene (38, 39) geführten elektrischen Anschluß (44) aufweist.

## Claims

1. Transversal coupled-mode SAW resonator filter having at least two resonators which are electrically and acoustically coupled to one another via a common busbar (25) and each have at least one interdigital transducer (11, 21) and at least two reflectors (12, 13, 22, 23) arranged on opposite sides of the interdigital transducer (11, 21), with one of the interdigital transducers (11) forming an electrical filter input (14), the other interdigital transducer (21) on the opposite side of the common busbar (25) forming an electrical filter output (24), and the common busbar (25) forming an electrical earth connection (26), **characterized** in that electrode fingers (30 to 33, 34 to 37) are arranged in at least one of the interdigital transducers such that one half of the electrode fingers (30 to 33) forms a mirror image of the other half of the electrode fingers (34 to 37) with respect to a mirror-image axis lying at right angles to the SAW propagation direction (50) and in that, in this at least one interdigital transducer, that busbar (38, 39) for the two electrode finger halves (30 to 33, 34 to 37) which is located on the opposite side of the common busbar (25) is separated to form two filter connections (40, 42), which together form a symmetrical filter input or output.

2. Resonator filter according to Claim 1, **characterized** in that the common busbar (25) has an electrical connection (44) which is routed between the separation point of the separated busbar (38, 39).

## Revendications

1. Filtre résonateur à couplage transversal de modes, à ondes acoustiques de surface, comportant au moins deux résonateurs, qui sont couplés mutuellement acoustiquement et électriquement par l'intermédiaire d'une barre (25) collectrice commune et qui comportent chacun au moins un transducteur (11, 21) interdigité et au moins deux réflecteurs (12, 13, 22, 23) disposés sur des côtés opposés du transducteur (11, 21) interdigité, l'un des transducteurs (11) interdigités formant une entrée (14) électrique de filtre, l'autre transducteur (21) interdigité sur le côté opposé à la barre (25) collectrice commune formant une sortie (24) électrique de filtre et la barre (25) collectrice commune formant une borne (26) électrique à la terre,
caractérisé en ce que
dans au moins l'un des transducteurs interdigités des doigts (30 à 33 ; 34 à 37) d'électrode sont disposés de sorte que, par rapport à un axe de miroir orthogonal à la direction (50) de propagation des ondes acoustiques de surface, une moitié des doigts d'électrode (30 à 33) sont symétriques comme en un miroir de l'autre moitié des doigts (34 à 37) d'électrode, et en ce que dans ce dit au moins un transducteur interdigité la barre collectrice (38, 39) se trouvant du côté opposé de la barre collectrice (25) commune est séparée pour les deux moitiés (30 à 33 ; 34 à 37) de doigts d'électrode pour former deux bornes (40, 42) de filtre, qui ensemble forme une entrée ou sortie de filtre symétrique.

2. Filtre résonateur suivant la revendication 1, caractérisé en ce que la barre (25) collectrice commune comporte une borne (44) électrique guidée entre le point de séparation des barres (38, 39) collectrices séparées.
